# EUROPEAN PATENT APPLICATION

(11) **EP 2 288 240 A2**
(43) Date of publication of application: **23.02.2011**
(21) Application number: 10008337.7
(22) Date of filing: 10.08.2010
(51) Int. Cl.: H05K 3/26, B23K 1/20

(54) **Plasma treatment of organic solderability preservative coatings during printed circuit board assembly.**

(30) Priority: 20.08.2009 CN 200910170404
(71) Applicant: Linde Aktiengesellschaft, 80331 München (DE)
(72) Inventor: Laumen, Christoph, 80634 München (DE); Feng, Edward, 200129 Shanghai (CN); Zhang, Bill, 200433 Shanghai (CN)

(57) **Abstract**

The present invention relates to the assembly of printed circuit boards (PCBs) and especially to the treatment of organic solderability preservative (OSP) coatings used during the manufacture of printed circuit board assemblies (PCBA). The present invention provides methods of removing OSP coatings prior to reflow soldering comprises using a plasma atmosphere to treat and remove the OSP coating.

## Description

### FIELD OF THE INVENTION

The present invention relates to the assembly of printed circuit boards and more particularly to the treatment of organic solderability preservative coatings used during the manufacturing of printed circuit board assemblies.

### BACKGROUND OF THE INVENTION

Printed circuit boards (PCBs) are used to mechanically support and electrically connect electronic components by using conductive pathways, or traces, generally etched from copper sheets that have been laminated unto a non-conductive substrate. The result is a printed wiring board or etched wiring board, and once populated with electronic components is generally referred to as a printed circuit assembly or a printed circuit board assembly (PCBA).

As noted the conductive layers for a PCB are generally made from a thin copper foil layer that has been patterned to create the traces used to connect and interconnect the electronic components. Originally, components included leads that were mounted and soldered into holes drilled into the PCB to contact the conducting copper layer. This drilling process requires very precise, very small mechanical bits, or very accurate laser drilling techniques. More recently, this "through-hole" construction method has been increasingly replaced with "surface-mount" construction, wherein the components are places on conductive pads on the outer surfaces of the PCB and then electrically and mechanically affixed to the PCB using solder.

Surface mounting has several advantages over through-hole techniques, including the ability to attach smaller components to the PCB, allowing a much higher number of components and many more connections per component, the need for fewer holes to be drilled, simplified, automated and faster assembly, two sided assembly capability, better mechanical performance, and lower component cost.

In the prior art, the coating layer of conductive pads was usually made from a tin-lead alloy, but with the restrictions placed on the use of lead in electronic devices by the RoHS (Restriction of Hazardous Substances) directive, the use of Pb-free coatings on copper conductive pads has become standard. The components are attached to the copper pads by various soldering techniques, the most popular being known as reflow soldering. Reflow soldering comprises the use of a solder paste, i.e. a sticky mixture of powdered solder and flux, that temporarily holds components to the pads. The assembly is then carefully heated, such as by infrared lamp or hot air convection in an oven, to complete soldering of the connection. The reflow soldering process melts the solder alloy particles in the solder paste, without overheating or damaging the electrical components and forms a strong, long-lasting metallurgical bond between the components and the conductive pads, providing both structural integrity and electrical conductivity for the electronic circuits. Standard reflow soldering processes are carried out in four stages or "zones", each having a distinct thermal profile; i.e. preheat, thermal soak, reflow and cooling.

In order for the soldering process to create effective and solid mechanical and electrical connection between the pad and component, it is necessary that the copper pad be clear of any surface contaminates, including oxides that may be present. Because copper is easily oxidized, a protective layer know as an organic solderability preservative (OSP) coating is provided on the copper pad surface until the reflow soldering process begins. However, the OSP coating needs to be removed to expose the copper pad for the reflow soldering process to be effective.

There are two main methods used to remove the OSP layer before reflow soldering, both of which have disadvantages. In a first method, a special chemical solvent may be applied to the OSP layer prior to solder paste printing. This solvent acts to dissolve the OSP layer and prepare the copper pad surface for solder paste printing. Disadvantages of this method include an additional operation step that adds to the time, material and energy costs associated with production. In addition, this method generates additional waste water.

The second known method for removing the OSP layer is to use a more highly reactive flux in the solder paste mixture, such flux serving to dissolve the OSP layer during the pre-heat stage. This method can also add cost and waste to the process, but has a more serious problem associated with continuing device miniaturization. In particular, as the electronic component size continues to decrease, the size of the conductive pads and the gap between components on the PCB also decreases. This in turn results in the need to use less solder paste and thus less flux for any particular pad. The reduced amounts of flux may not be effective to completely dissolve the OSP layer which could cause both quality and reliability issues for the solder joint.

Therefore, there is a need in the art for improvements to methods of producing PCB assemblies and particularly to the removal of OSP layers from conducive pads prior to reflow soldering processes.

### SUMMARY OF THE INVENTION

The present invention relates to the assembly of PCBs and to the treatment of OSP coatings used during the manufacturing of PCBA. In particular, the present invention provides improved methods of removing OSP coatings prior to reflow soldering that overcome the disadvantages noted above with respect to the prior art. The improved method of the present invention comprises using a plasma atmosphere to treat and remove the OSP coating.

### BRIEF DESCRIPTION OF THE DRAWINGS

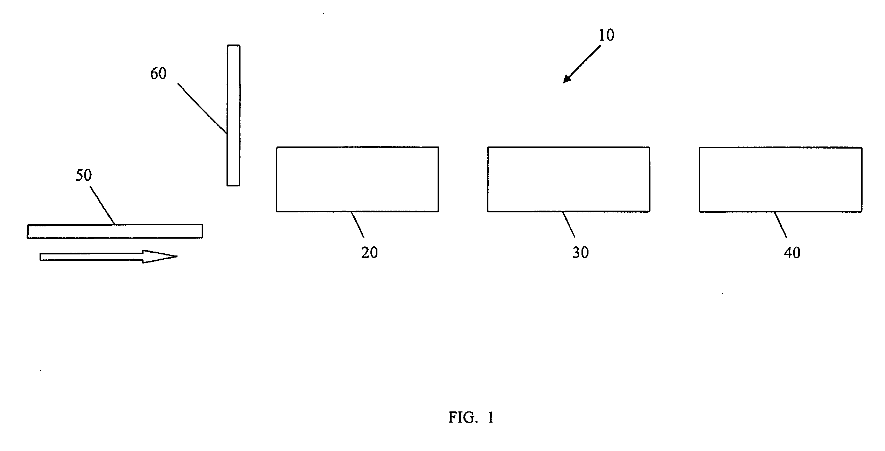

Figure 1 is a schematic diagram showing a process for treating an OSP layer of a PCB in accordance with one embodiment of the present invention.

### DETAILED DESCRIPTION OF THE INVENTION

The present invention is directed toward improvements in the treatment and removal of OSP coatings prior to reflow soldering of a PCB. In particular, the present invention uses a plasma atmosphere to treat and remove the OSP coating prior to the PCB entering the reflow soldering process. The method of the present invention overcomes the disadvantages associated with the prior art methods of removing the OSP. In particular, no special solvents or special reflux materials are needed in the present invention, thus eliminating extra material costs and considerations. In addition, the plasma atmosphere can be created within current stream lined operating systems. Moreover, the method of the present invention does not generate additional waste water and can be used effectively even with smaller electronic component sizes without reduction of quality or reliability of the solder joint.

The present invention will be described in more detail with reference to Figure 1, wherein a reflow soldering system 10, is generally depicted as comprising a solder paste printing station 20, a component Pick&Place station 30 and a reflow station 40. Also shown is a PCB 50 having an OSP layer in place and a plasma source 60. In operation the PCB 50 having the OSP layer moves toward the reflow soldering system 10 in the direction of the arrow shown in Figure 1, generally by means of a conveyor belt. The plasma source 60 is placed just before the area where the PCB 50 enters the system 10 and provides a plasma atmosphere capable of removing the OSP layer. The plasma source 60 can be any known plasma generator, such as an atmospheric plasma gun and may consist of a series of nozzles arranged to ensure that the entire width of the PCB 50 is blanketed with the plasma atmosphere. The nozzles are preferably situated so as to provide the plasma horizontally onto the surface of the PCB, but other arrangements, including slanted nozzles are within the scope of the present invention. The series of nozzles can be incorporated on top of the conveyor belt. The plasma generated can be any suitable gas for removing the OSP, for example, oxygen, argon or mixtures thereof with nitrogen. The distance between the outlet of the plasma source 60 and the PCB 50 at the point of treatment should be 10 mm or less.

By using a plasma source as described above, the OSP layer can be easily etched away and the copper pads readied for the solder paste printing step. As noted, disadvantages of the prior art methods are avoided. In particular, the use of special solvents or special reflux materials is not necessary. Further, the plasma source is installed in the manufacturing line and does not add any processing time to the overall production process.

The use of plasma cleaning of the conductive pad of a PCB may be beneficial at other stages in the process as well. In particular, plasma or activated gases could be used to clean the solder pad directly before and during the soldering step.

It will be understood that the embodiments described herein are merely exemplary and that one skilled in the art may make variations and modifications without departing from the spirit and scope of the present invention. All such variations and modifications are intended to be included within the scope of the invention as described above. Further, all embodiments disclosed are not necessarily in the alternative, as various embodiments of the invention may be combined to provide the desired result.

## Claims

1. A method of removing an organic solderability preservative coating from a printed circuit board, comprising:
subjecting the printed circuit board to a plasma atmosphere prior to the printed circuit board being processed in a reflow soldering system.

2. The method of claim 1, wherein the plasma atmosphere is at least one of oxygen, argon or mixtures thereof with nitrogen.

3. A reflow soldering system for manufacturing printed circuit boards, comprising:
a solder paste printing station;
a component pick&place station;
a reflow soldering station; and
a plasma atmosphere source located prior to the solder paste printing station.

4. A system according to claim 3, wherein the plasma atmosphere source comprises a plasma generator.

5. A system according to claim 4, wherein the plasma generator is a plasma gun with a series of nozzles arranged to blanket the printed circuit board with the plasma atmosphere.

6. A system according to claim 5, wherein outlets of the nozzles are arranged horizontally to the surface of the printed circuit board.

7. A system according to claim 5, wherein outlets of the nozzles are arranged at an angle to the surface of the printed circuit board.

8. A system according to claim 5, wherein outlets of the nozzles are located 10mm or less from the surface of the printed circuit board.

9. A system according to claim 3, wherein the plasma atmosphere source is a source of oxygen, argon or mixtures thereof with nitrogen.
